# EUROPEAN PATENT SPECIFICATION

(11) **EP 0 434 873 B1**
(45) Date of publication and mention of the grant of the patent: **17.11.1994**
(21) Application number: 89313658.0
(22) Date of filing: 28.12.1989
(51) Int. Cl.: H01L 23/498

(54) **A tape-like carrier for mounting an integrated circuit**
Bandähnlicher Träger zum Montieren einer integrierten Schaltung
Support du type à bande pour le montage d'un circuit intégré

(43) Date of publication of application: 03.07.1991
(73) Proprietor: NEC CORPORATION, Tokyo (JP)
(72) Inventor: Iwata, Yuji c/o NEC Corporation, Minato-ku Tokyo (JP)
(74) Representative: Moir, Michael Christopher

(56) References cited:
- US-A- 4 048 438

## Description

The present invention relates to a tape-like carrier for mounting an integrated circuit, and more particularly to the tape-like carrier used for tape automated bonding in which plural inner leads are automatically bonded to a semiconductor pellet. Further the present invention relates to the tape-like carrier suitable for the connection of multiple terminals of a semiconductor pellet with electronic elements.

Heretofore well known is a longitudinally extending tape-like carrier for the mounting of an integrated circuit including sets of leads secured to a flexible insulating film having longitudinally spaced apertures which are dimensioned to encompass contact regions of the semiconductor pellet, said leads extending from the periphery of the every aperture toward the inside thereof (US-A-3,689,991).

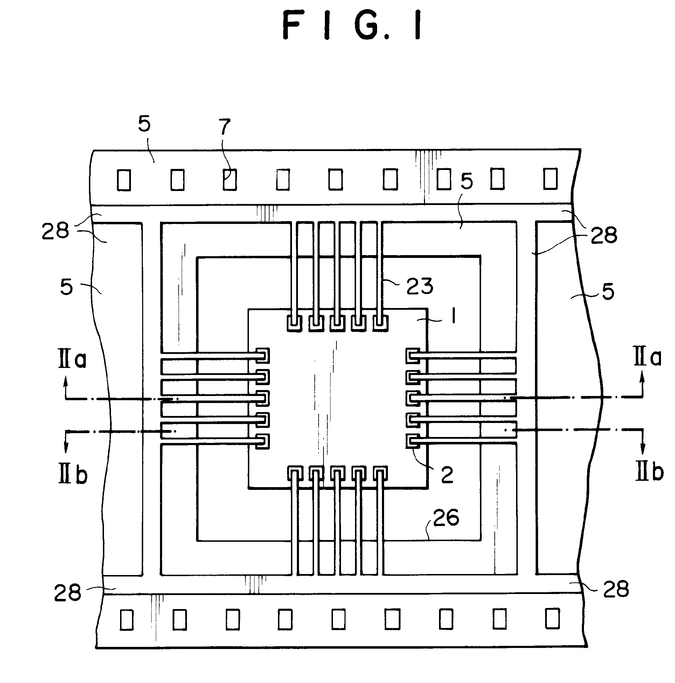

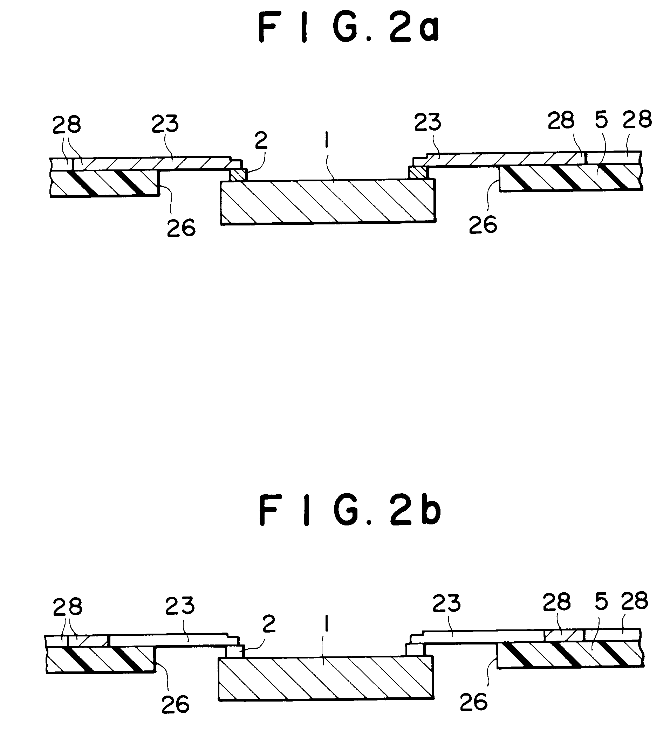

Figs. 1 to 2b show one prior illustration of such a tape-like carrier for mounting an integrated circuit, together with a semiconductor pellet having bump electrodes with leads, Fig. 1 being a plan view, Fig. 2a being a cross-sectional view taken on line IIa-IIa of Fig. 1 and Fig. 2b being a cross-sectional view taken on IIb-IIb of Fig. 1.

With reference to Figs. 1 to 2b, the conventional tape-like carrier for mounting an integrated circuit comprises a flexible insulating film 5 in the form of tape made of polyimide. The flexible insulating film 5 is provided with sprocket holes 7 at regular intervals along the longitudinal direction in both side regions thereof. Further the flexible insulating film 5 has longitudinally spaced apertures 26 which are dimensioned to encompass a contact region of the semiconductor pellet.

Longitudinally spaced sets of leads 23 and bars 28 in the form of a frame leading to the leads 23 are formed on the flexible insulating film 5. The leads 23 extend within the periphery of a respective aperture 26 for the semiconductor pellet. Between the individual leads 23, and between the leads 23 and the bars 28, a surface of the flexible insulating film 5 is partially exposed.

Located in the center of the aperture 26 is a semiconductor pellet 1 having plural bump electrodes 2 formed on the contact region of the pellet 2. The bump electrodes 2 are bonded to the corresponding leads 23 which are arranged at regular intervals so as to be coincident with the bump electrodes 2, by a heat bonding method using a bonding tool, that is, gang bonding.

When bonding of multiple inner leads with multiple bumps 2 of a semiconductor pellet is performed using the above tape-like carrier for mounting an integrated circuit, the heat dissipation characteristic is significantly worse so that the following inconvenience occurs: i.e., as the metal regions which dissipate the heat of the leads 23 conducted from the bonding tool are only the surfaces of the bars 28 and the leads 23, the efficiency of heat dissipation is low.

Therefore, when inner lead bonding is performed by using the above tape-like carrier for mounting an integrated circuit, thermal expansion of the leads 23 and the deformation and the contraction of the flexible insulating film 5 occur which results in the change of pitches between the leads 23. Thereby, outer lead bonding for mounting the semiconductor pellet 1 to a substrate (not shown) or to an outer lead frame cannot be normally performed in a postprocess, which results in faulty bonding.

A tape-like carrier for mounting an integrated circuit is known from US-A-4,048,438. In this document, an improved conductor patterned substrate assembly is disclosed which permits direct attachment of integrated circuit chips to a metallized array while preventing stress buildup due to thermal cycling and/or bonding temperatures. A circuit is formed on a flexible substrate of insulative material which is suitable for withstanding solder, thermal compression bonding, or eutectic die attachment temperatures. The circuit includes a fine line pattern of leads extending up to the edge of a hole in the substrate substantially centered within the pattern of the integrated circuit pad dimensions. The subject assembly can thus be used for face down bonding of integrated circuit chips which have bump metallization on the contact pads thereof. Thermal distortion of the substrate during bonding is minimized by the central hole thus preventing undue stresses from being applied to the chip bonds by the substrate. The assembly also provides for full support for the conductor leads throughout their entire length, in order to maintain dimensional and spatial stability especially for bonding larger multi-pad chips.

The present invention seeks to provide a tape-like carrier for mounting an integrated circuit which has a high efficiency of heat dissipation and by which the faulty outer bonding can be solved.

According to the present invention, there is provided a tape-like carrier for mounting an integrated circuit, comprising: a tape-shaped flexible insulating film, formed at two opposite edge regions thereof with sprocket holes, said film including a plurality of apertures each being dimensioned to encompass a contact region of a semiconductor pellet, said apertures being provided along a length-wise direction of said tape-shaped flexible insulating film; heat radiation metallic films attached to one of the surfaces of said insulating film and provided over the area thereof to peripherally surround each of said apertures; conductive bars provided on said insulating film in spaced relationship from said sprocket holes, adjacent metallic films being connected to each other by said conductive bars and being spaced from said sprocket holes; and leads extending from a respective edge of each of said metallic films inwardly of each of said apertures so as to be able to contact said contact region of said semiconductor pellet, the arrangement being such that the leads do not overlap said insulating film; whereby said metallic films are in contact with said leads and form metal regions around each of said apertures to provide heat dissipation from said leads.

In the present invention, the term "contact region of a semiconductor pellet" includes regions of the semiconductor pellet in which plural bump electrodes are formed.

In the present invention, said leads are preferably formed integrally with said metallic radiation films, the edge of each of the metallic radiation films along the periphery of the aperture conforming to the periphery of the aperture or extending only within the periphery of the aperture.

In the present invention, as the flexible insulating film, use can be made of polyester, polyimide or other dielectric plastic films; however use can be preferably made of polyimide because of its thermal stability and resistance to dimensional changes under stress.

In the present invention the metallic radiation films act to radiate the heat of the leads.

As material of the metallic radiation films, metal or alloy, for example copper, aluminium, tin, gold, silver or copper alloy can be applied. However, copper or copper alloy can be preferably used as material of the metallic radiation films, because the metallic radiation films can be formed integrally with the leads.

The metallic radiation films which are adjacent to each other are electrically connected with each other through bars, so that current can be conducted through the metallic radiation films and the bars to the leads, whereby electroplating of metal such as gold on the leads is possible.

In the present invention, each metallic radiation film can have a thickness greater than that of the leads, by which feature the heat of the leads can be more efficiently removed from the leads, since the heat of the leads can be immediately conducted to the thicker metallic radiation film 14.

In the present invention, since the heat of the leads is immediately conducted to the metallic radiation films and the heat is radiated from the surfaces of the metallic radiation films, heat expansion of the leads and the deformation and the contraction of the flexible insulating film can be avoided.

Accordingly, since the pitch between the leads can be always maintained at the given interval, outer lead bonding can be successfully performed.

Preferred features of the present invention are now described, by way of example only, with reference to the accompanying drawings, in which:
Figs. 1, 2a and 2b show a conventional tape-like carrier for mounting of integrated circuit, together with a semiconductor pellet having bumps which are bonded with leads, Fig. 1 being a plan view thereof, Fig. 2a being a cross-sectional view thereof taken on line IIa-IIa of Fig. 1, and Fig. 2b being a cross-sectional view thereof taken on line IIb-IIB of Fig. 1;
Figs. 3, 4a and 4b show a first embodiment of the present invention, Fig. 3 being a plan view thereof, Fig. 4a being a cross-sectional view thereof taken on line IVa-IVa of Fig. 3, and Fig. 4b being a cross-sectional view thereof taken on line IVb-IVb of Fig. 3;
Figs. 5 (a) to (c) are cross-sectional views showing processes of inner lead bonding by using the tape-like carrier for mounting an integrated circuit of the first embodiment respectively;
Figs. 6, 7a and 7b show a second embodiment of the present invention, Fig. 6 being a plan view thereof and Fig. 7a being a cross-sectional view thereof taken on line VIIa-VIIa of Fig. 6, and Fig. 7b being a cross-sectional view thereof taken on line VIIb-VIIb of Fig. 6.

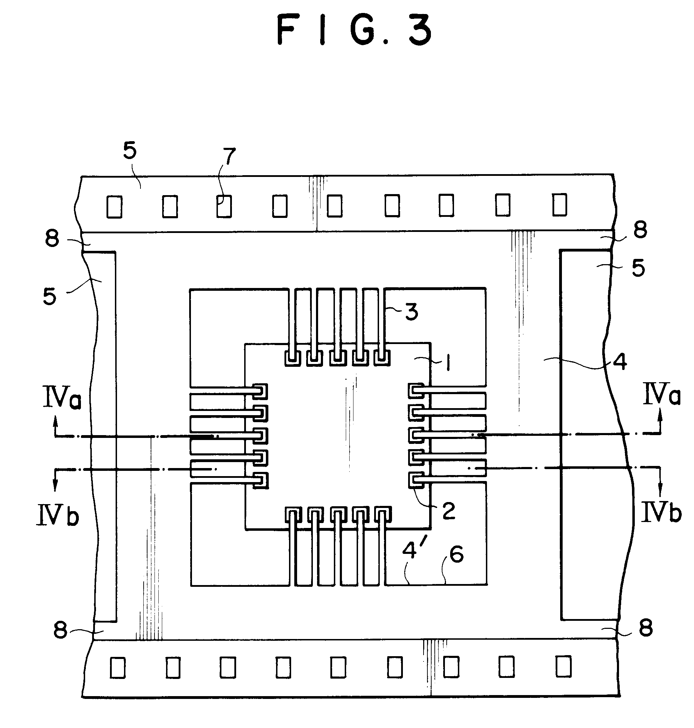

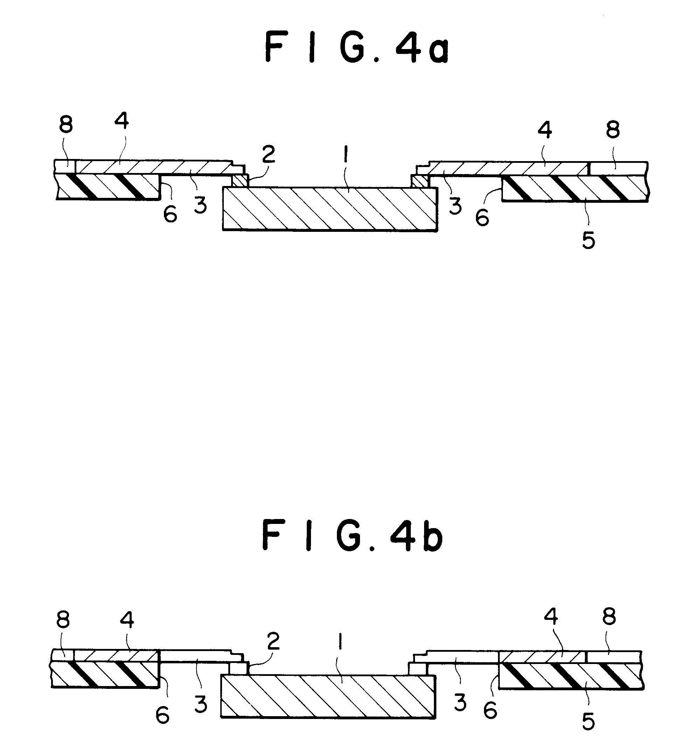

Figs. 3 to 4b show a first embodiment of the present invention.

A tape-like carrier for mounting an integrated circuit according to the present invention comprises a flexible insulating film 5 in the form of tape, preferably made of polyimide. The flexible insulating layer 5 is provided with plural sprocket holes 7 at regular intervals along the longitudinal direction in both side regions thereof in the same manner as the conventional one. Further, the flexible insulating film 5 has longitudinally spaced apertures 6 which are dimensioned to encompass contact regions of the semiconductor pellet 1 in which the plural bump electrodes 2 are formed.

Metallic radiation films 4 for radiating the heat of the leads in the case of inner lead bonding are laminated on the whole marginal zone of the flexible insulating film along the whole periphery of the respective aperture 6, except for both the side regions of the flexible insulating film 5. The edge 4′ of the metallic radiation film along the periphery of the respective aperture 6 conforms to the periphery of the respective aperture 6. The metallic radiation films 4 are made of metal or alloy, for example, copper or copper alloy. The metallic radiation films 4 which are adjacent to each other are connected with each other through bars 8 positioned between the metallic radiation films 4 along both the side regions of the flexible insulating film 5 so that current can be conducted through the metallic radiation films 4 and the bars 8 to the leads 3, whereby electroplating of metal such as gold on the leads is possible. Further, leads 3 integral with the respective metallic radiation film 4 project from the respective metallic radiation film 4 around the respective aperture 6 for the semiconductor pellet 1 toward the inside thereof.

The tape-like carrier for mounting the integrated circuit of this embodiment can be obtained by the following method. The apertures 6 for the semiconductor pellet 1 and the sprocket holes 7 are made in the flexible insulating film 5, for example made of polyimide film strip. Then, foil of metal or alloy, for example copper foil or copper alloy foil, is laminated with the flexible insulating film 5 through an adhesive layer. Thereafter a pattern of photoresist is formed on the foil of metal or alloy and the unwanted metal or alloy region is etched away in accordance with a known etching method to form the leads 3 and the metallic films 4 for radiating heat.

Using the tape-like carrier for mounting an integrated circuit manufactured in the above-mentioned method, inner lead bonding of the leads 3 with the bumps 2 provided on the semiconductor pellet 1 can be performed with a bonding tool as in the conventional method.

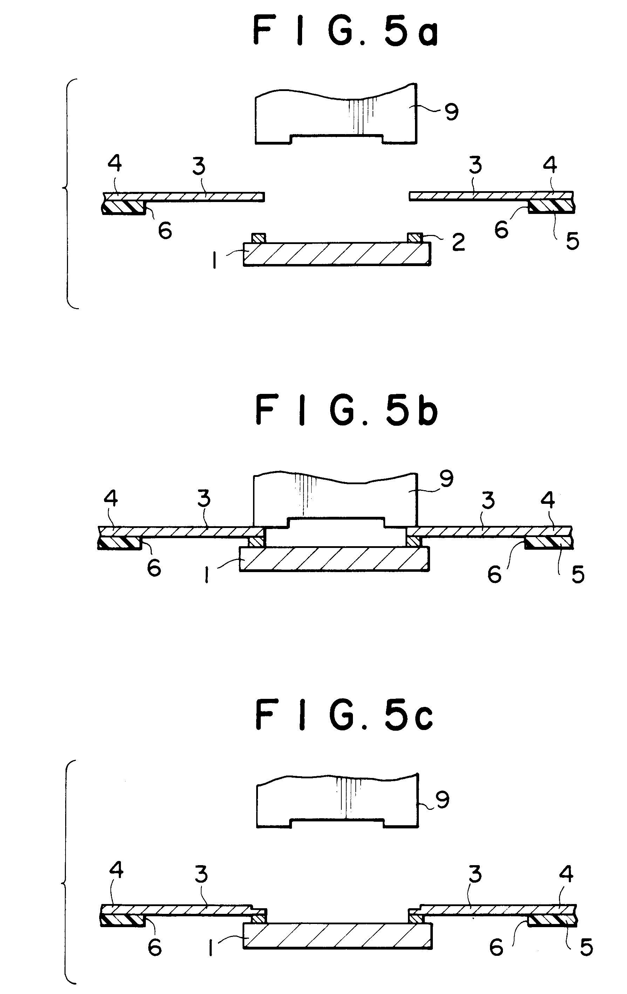

Then, with reference to Figs. 5 (a) to (c), a method of inner lead bonding using a tape-like carrier for mounting an integrated circuit according to this embodiment is explained.

First, as shown in Fig. 5 (a), a semiconductor pellet 1 is located at such position that bump electrodes 2 are opposite to raised parts of a bonding tool 9, respectively, and the tape-like carrier for mounting the integrated circuit of this embodiment is arranged at such position that the leads 3 are opposite to the bump electrodes 2, respectively. As above-mentioned, the leads 3 are integral with the metallic radiation film 4 on the flexible insulating film 5 and project from the metallic radiation film 4 around the aperture 6 toward the inside thereof.

Then, as shown in Fig. 5 (b), plural leads 3 are registered with plural bump electrodes 2 and heat-sealed to the corresponding bump electrodes 2, respectively.

Then as shown in Fig. 5 (c), the bonding tool 9 is released from the semiconductor pellet 1, thereby ending the inner lead bonding.

In the present invention, heat fed from the bonding tool 9 to ends of the leads 3 during the inner lead bonding is conducted through the leads 3 to the metallic radiation films 4 provided on the flexible insulating layer 5 around the respective aperture 6 and radiated from the surfaces of the metallic radiation films 4. Therefore, a rise of the temperature of the leads 3 and the flexible insulating film 5 under the leads 3 in the bonding process is much lower as compared with a conventional tape-like carrier for mounting an integrated circuit as shown in Fig. 1. Therefore heat expansion of the leads 3 and the deformation and the contraction of the flexible insulating film can be avoided.

Accordingly, since the pitch between the leads can be always maintained at the given interval, outer lead bonding can be successfully performed.

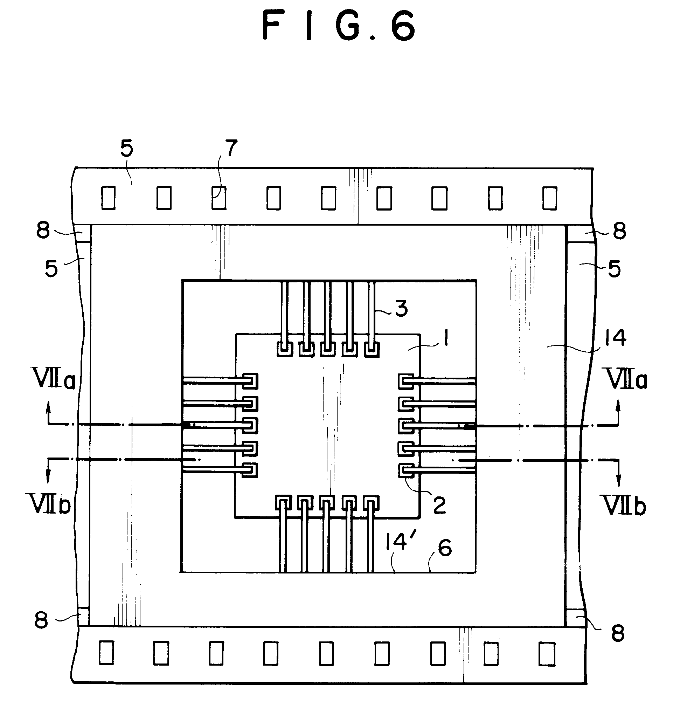

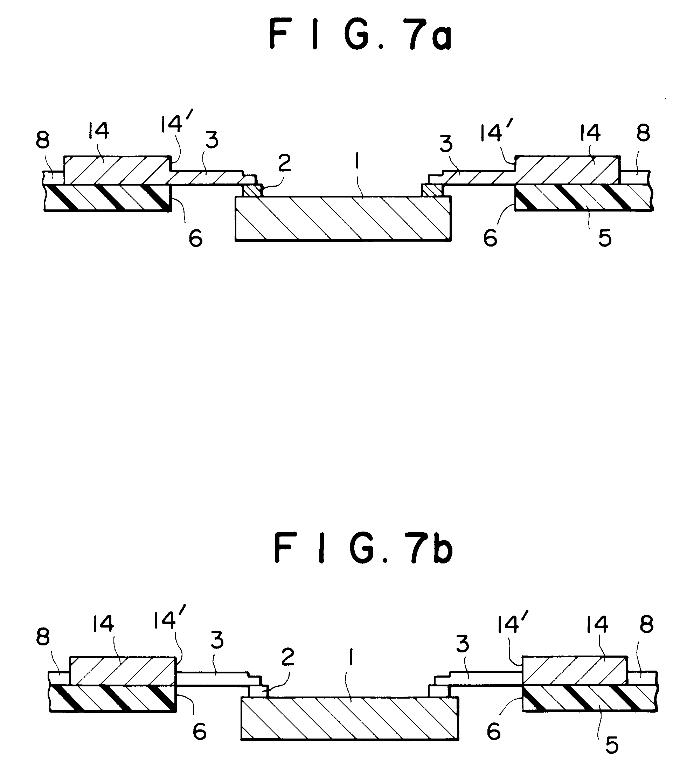

Figs. 6 to 7b show a second embodiment of the present invention.

The second embodiment is the same as the first embodiment, except that the metallic radiation film 14 has a thickness greater than that of the leads 3.

In Figs. 6 to 7b, the same reference numbers designate like parts as in Figs. 3 to 4b. Explanation of such parts is therefore omitted.

According to the second embodiment, the heat of the leads 14 can be more efficiently removed from the leads during inner lead bonding since the heat of the leads is immediately conducted to the thicker metallic radiation film and released from the surface thereof; therefore the pitch between the leads can be precisely maintained at the given interval so that outer lead bonding can be successfully performed.

## Claims

1. A tape-like carrier for mounting an integrated circuit, comprising:
a tape-shaped flexible insulating film (5), formed at two opposite edge regions thereof with sprocket holes (7), said film including a plurality of apertures (6) each being dimensioned to encompass a contact region of a semiconductor pellet (1), said apertures being provided along a length-wise direction of said tape-shaped flexible insulating film;
heat radiation metallic films (4,14) attached to one of the surfaces of said insulating film (5) and provided over the area thereof to peripherally surround each of said apertures (6);
conductive bars (8) provided on said insulating film (5) in spaced relationship from said sprocket holes (7), adjacent metallic films being connected to each other by said conductive bars and being spaced from said sprocket holes; and
leads (3) extending from a respective edge (4′;14′) of each of said metallic films (4;14) inwardly of each of said apertures so as to be able to contact said contact region of said semiconductor pellet (1), the arrangement being such that the leads do not overlap said insulating film (5);
whereby said metallic films (4;14) are in contact with said leads (3) and form metal regions around each of said apertures to provide heat dissipation from said leads.

2. A tape-like carrier as claimed in Claim 1, wherein the edges (4′;14′) of said metallic films conform to or extend within the periphery of their respective apertures.

3. A tape-like carrier as claimed in Claim 1 or 2, wherein each of said leads (3) is integral with its respective metallic film (4;14).

4. A tape-like carrier as claimed in Claim 1, 2 or 3, wherein said metallic films (4;14) have a thickness greater than that of said leads (3).

5. A tape-like carrier as claimed in any of Claims 1 to 4, wherein each of said metallic films (4;14) includes a film made of metal or an alloy thereof.

6. A tape-like carrier as claimed in any of Claims 1 to 4, wherein each of said metallic films (4;14) includes a film made of copper or a copper alloy.

7. A tape-like carrier as claimed in any of the preceding claims, wherein said flexible insulating film (5) is a polyimide film.

8. A tape-like carrier as claimed in any of the preceding claims, including a respective semiconductor pellet (1) for each of said apertures (6).

9. A tape-like carrier as claimed in Claim 8, wherein the contact regions of the semiconductor pellets are regions of the pellets which include plural bump electrodes (2).

## Patentansprüche

1. Bandförmiger Träger zum Montieren einer integrierten Schaltung, der aufweist:
einen bandförmigen flexiblen isolierenden Film (5), der an seinen zwei gegenüberliegenden Randbereichen mit Transportlöchern (7) versehen ist, wobei der Film eine Vielzahl von Öffnungen (6) aufweist, von denen jede so dimensioniert ist, daß sie einen Kontaktbereich eines Halbleiterchips (1) umfaßt, wobei die Öffnungen entlang einer Längsrichtung des bandförmigen flexiblen isolierenden Films vorgesehen sind;
wärmestrahlende metallische Filme (4;14), die an einer der Oberflächen des isolierenden Films (5) befestigt sind und über die Fläche desselben vorgesehen sind, um am Umfang jede der Öffnungen (6) zu umgeben;
leitende Streifen (8), die auf dem isolierenden Film (5) beabstandet von den Transportlöchern (7) vorgesehen sind, wobei benachbarte metallische Filme miteinander durch diese leitenden Streifen verbunden sind und in einem Abstand von den Transportlöchern angeordnet sind; und
Anschlußleitungen (3), die sich von einem entsprechenden Rand (4′;14′) jedes der metallischen Filme (4;14) von jeder der Öffnungen nach innen erstrecken, so daß sie mit dem Kontaktbereich des Halbleiterchips (1) in Berührung kommen können, wobei die Anordnung so ist, daß die Anschlußleitungen nicht mit dem isolierenden Film (5) überlappen;
wodurch die metallischen Filme (4;14) in Berührung mit den Anschlußleitungen (3) sind und Metallbereiche um jede der Öffnungen bilden, um eine Wärmeableitung von den Anschlußleitungen weg zu erzielen.

2. Bandförmiger Träger nach Anspruch 1, bei dem die Ränder (4′;14′) des metallischen Films mit dem Umfang ihrer entsprechenden Öffnungen übereinstimmen oder sich innerhalb dieses Umfangs erstrecken.

3. Bandförmiger Träger nach Anspruch 1 oder 2, bei dem jede der Anschlußleitungen (3) mit ihrem entsprechenden metallischen Film (4;14) einstückig ausgebildet sind.

4. Bandförmiger Träger nach Anspruch 1, 2 oder 3, bei dem die metallischen Filme (4;14) eine Dicke haben, die größer ist als diejenige der Anschlußleitungen (3).

5. Bandförmiger Träger nach einem der Ansprüche 1 bis 4, bei dem jeder der metallischen Filme (4;14) einen Film einschließt, der aus Metall oder aus einer Legierung desselben hergestellt ist.

6. Bandförmiger Träger nach einem der Ansprüche 1 bis 4, bei dem jeder der metallischen Filme (4;14) einen Film einschließt, der aus Kupfer oder einer Kupferlegierung hergestellt ist.

7. Bandförmiger Träger nach einem der vorstehenden Ansprüche, bei dem der isolierende Film (5) ein Polyimidfilm ist.

8. Bandförmiger Träger nach einem der vorstehenden Ansprüche, der einen entsprechenden Halbleiterchip (1) für jede der Öffnungen (6) aufweist.

9. Bandförmiger Träger nach Anspruch 8, bei dem die Kontakt bereiche der Halbleiterchips Bereiche der Chips sind, die eine Vielzahl von Höckerelektroden (2) einschließen.

## Revendications

1. Support du type à bande pour le montage d'un circuit intégré, comprenant :
une pellicule isolante flexible en forme de bande (5), présentant aux deux zones opposées de ses bords des perforations d'entraînement (7), ladite pellicule comprenant une multitude d'ouvertures (6), chacune étant dimensionnée de façon à renfermer une zone de contact d'une pastille de semi-conducteur (1), lesdites ouvertures étant ménagées dans le sens de la longueur de ladite pellicule isolante flexible en forme de bande;
des pellicules métalliques rayonnant la chaleur (4; 14) fixées à l'une des surfaces de ladite pellicule isolante (5) et prévues sur la surface de celle-ci pour entourer périphériquement chacune desdites ouvertures (6);
des barres conductrices (8) prévues sur ladite pellicule isolante (5) en relation d'espacement par rapport auxdites performations d'entraînement (7), des pellicules métalliques adjacentes étant connectées l'une à l'autre par lesdites barres conductrices et étant espacées desdites perforations d'entraînement; et
des fils (3) s'étendant à partir d'un bord respectif (4′;14′) de chacune desdites pellicules métalliques (4; 14) vers l'intérieur de chacune desdites ouvertures de manière à pouvoir être en contact avec ladite zone de contact de ladite pastille de semi-conducteur (1), l'agencement étant tel que les fils ne chevauchent pas ladite pellicule isolante (5);
d'où il résulte que lesdites pellicules métalliques (4; 14) sont en contact avec lesdits fils (3) et forment des zones métalliques autour de chacune desdites ouvertures de manière à assurer la dissipation de la chaleur à partir des fils.

2. Support du type à bande selon la revendication 1, dans lequel les bords (4′; 14′) desdites pellicules métalliques sont conformes à ou s'étendent à l'intérieur de la périphérie de leurs ouvertures respectives.

3. Support du type à bande selon la revendication 1 ou 2, dans lequel chacun desdits fils (3) est en une pièce avec sa pellicule métallique respective (4; 14).

4. Support du type à bande selon la revendication 1, 2 ou 3, dans laquelle lesdites pellicules métalliques (4; 14) ont une épaisseur supérieure à celle desdits fils (3).

5. Support du type à bande selon l'une quelconque des revendications 1 à 4, dans lequel chacune desdites pellicules métalliques (4; 14) comportent une pellicule en métal ou en alliage de ce dernier.

6. Support du type à bande selon l'une quelconque des revendications 1 à 4, dans lequel chacune desdites pellicules métalliques (4; 14) comportent une pellicule de cuivre ou d'alliage de cuivre.

7. Support du type à bande selon l'une quelconque des revendications précédentes, dans lequel ladite pellicule isolante flexible (5) est une pellicule de polyimide.

8. Support du type à bande selon l'une quelconque des revendications précédentes, comprenant une pastille de semi-conducteur (1) respectivement pour chacune desdites ouvertures (6).

9. Support du type à bande selon la revendication 8, dans lequel les zones de contact des pastilles de semi-conducteur sont des zones des pastilles qui comportent plusieurs électrodes à protubérance (2).
